(19) Europäisches Patentamt / European Patent Office / Office européen des brevets

(11) **EP 4 675 670 A1**

(12) **EUROPEAN PATENT APPLICATION**
published in accordance with Art. 153(4) EPC

(43) Date of publication:
07.01.2026 Bulletin 2026/02

(21) Application number: 24763537.8

(22) Date of filing: 06.02.2024

(51) International Patent Classification (IPC):
*H01L 21/301* (2006.01)    *C08G 59/02* (2006.01)
*C08G 59/20* (2006.01)    *C09J 7/38* (2018.01)
*C09J 133/00* (2006.01)

(52) Cooperative Patent Classification (CPC):
C08G 59/02; C08G 59/20; C09J 7/38; C09J 133/00;
H01L 21/30

(86) International application number:
PCT/JP2024/003834

(87) International publication number:
WO 2024/181053 (06.09.2024 Gazette 2024/36)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 28.02.2023 JP 2023029173

(71) Applicant: FURUKAWA ELECTRIC CO., LTD.
Tokyo 100-8322 (JP)

(72) Inventor: ASANUMA, Takumi
Tokyo 100-8322 (JP)

(74) Representative: Zacco GmbH
Bayerstrasse 83
80335 München (DE)

(54) **TAPE FOR SEMICONDUCTOR PROCESSING**

(57) To provide a semiconductor processing tape, having excellent heat resistance even under the heating atmosphere of a reflow step. A semiconductor processing tape, in which a pressure-sensitive adhesive layer is formed on a substrate film, wherein the substrate film is a cured product of an epoxy compound-containing composition, and a thermal shrinkage ratio after retention under an atmosphere at 260°C for 10 minutes, of the semiconductor processing tape, is 5.0% or less.

EP 4 675 670 A1

**Description**

Technical Field

The present invention relates to a semiconductor processing tape which is for use in a manufacturing process of a semiconductor and which is coated with a pressure-sensitive adhesive layer, and particularly relates to a semiconductor processing tape which can be used in a plurality of steps including a heating step such as a reflow step.

Background Art

In recent years, electronic members such as semiconductors have continued to be increasingly advanced, and forms of thinner and more complicated devices have been demanded. In particular, in CoWS (Chip on Wafer on Substrate), the formation of boards such as silicon interposers for mutually connecting different chips is important. Electrodes are formed on both surfaces of silicon interposers, and each of the electrodes is bonded with chips and the like.

Silicon interposers are very thin and may be warped as they are, and therefore silicon interposers are entirely supported with plate-like supports (carriers). Solder bumps provided on chips are used to bond boards such as silicon interposers and such chips. In order to bond boards such as silicon interposers and solder, reflow steps with reflow furnaces as heating apparatuses are applied. Boards such as silicon interposers are reflow-treated in the state of being supported by supports.

After boards such as silicon interposers are reflow-treated in the state of being supported by supports, dicing tapes for use in dicing steps are attached so that boards such as silicon interposers are sandwiched between such dicing tapes and such supports. Dicing tapes are tapes for processing semiconductors, and are pressure-sensitive adhesive tapes for fixing and individuating semiconductor wafers. After dicing tapes are attached to boards such as silicon interposers, the supports are detached from the boards such as silicon interposers. Semiconductor wafers are diced in the state of adhering and being fixed to dicing tapes, and processed into individual semiconductor chips, and such semiconductor chips are picked up.

It has been necessary in conventional reflow steps and dicing steps described above to prepare supports of boards in reflow steps and dicing tapes for use in dicing steps, respectively, and a problem has been that the steps are complicated. It is then demanded that dicing tapes can also be applied in reflow steps, namely, dicing tapes can also be used as supports of boards in reflow steps.

In reflow steps, boards supported by supports are heat-treated in the state of being attached to ring frames as annular frame bodies. Accordingly, in order that dicing tapes can also be applied in reflow steps, dicing tapes are demanded not to be dropped out and peeled from ring frames even under the heating atmosphere (for example, about 260°C) in reflow steps. In other words, dicing tapes are demanded to have heat resistance imparted and be kept in the state of being attached to ring frames with heat shrinkage being prevented even under the heating atmosphere of reflow steps.

However, heat resistance applicable in reflow steps has not been imparted to conventional dicing tapes. On the other hand, cured products of epoxy resins are known as materials excellent in heat resistance, and there has been proposed use of a cured product of an epoxy resin in a film (Patent Literature 1).

However, in Patent Literature 1, heat resistance in an atmosphere at about 260°C as the temperature of a reflow step has not been considered and a problem has been that the thermal shrinkage ratio is high under an atmosphere at 260°C and a tape is dropped out and peeled from a ring frame.

Document List

Patent Literature

Patent Literature 1: Japanese Patent Application Publication No. 2021-123029

Summary of Invention

Technical Problem

In view of the above, an object of the present invention is to provide a semiconductor processing tape, having excellent heat resistance even under the heating atmosphere of a reflow step.

Solution to Problem

The present inventor has found that heat resistance applicable in a reflow step is imparted by using a pressure-sensitive adhesive tape which is a semiconductor processing tape, in which a pressure-sensitive adhesive layer is formed on a substrate film, the substrate film including an epoxy compound, and thus has led to completion of the present invention.

The gist of the configuration of the present invention is as follows.

[1] A semiconductor processing tape, in which a pressure-sensitive adhesive layer is formed on a substrate film, wherein

the substrate film is a cured product of an epoxy compound-containing composition, and
a thermal shrinkage ratio after retention under an atmosphere at 260°C for 10 minutes, of the semiconductor processing tape, is 5.0% or less.

[2] The semiconductor processing tape according to [1], wherein a fracture elongation under an atmosphere at 23°C, of the semiconductor processing tape, is 15% or more.

[3] The semiconductor processing tape according to [1] or [2], wherein a fracture elongation after retention under an atmosphere at 260°C for 10 minutes, of the semiconductor processing tape, is 15% or more.

[4] The semiconductor processing tape according to [1] or [2], wherein a tensile elastic modulus under an atmosphere at 260°C, of the semiconductor processing tape, is 0.5 MPa or more.

[5] The semiconductor processing tape according to [1] or [2], wherein the epoxy compound-containing composition includes at least two kinds of epoxy compounds.

[6] The semiconductor processing tape according to [5], wherein the two kinds of epoxy compounds are an epoxy compound having a cyclic hydrocarbon structure and an epoxy compound not having a cyclic hydrocarbon structure.

[7] The semiconductor processing tape according to [1] or [2], wherein the epoxy compound-containing composition includes an epoxy compound having an elastomeric backbone and an epoxy compound not having an elastomeric backbone.

[8] The semiconductor processing tape according to [6], wherein the epoxy compound not having a cyclic hydrocarbon structure is an epoxy compound having an elastomeric backbone.

[9] The semiconductor processing tape according to [1] or [2], wherein the epoxy compound-containing composition includes a film-forming agent and a crosslinking component composed of an epoxy compound, and a blending proportion of the crosslinking component composed of an epoxy compound to a total amount of the film-forming agent and the crosslinking component composed of an epoxy compound is 20% by mass or more and 80% by mass or less.

[10] The semiconductor processing tape according to [1] or [2], wherein a pressure-sensitive adhesive included in the pressure-sensitive adhesive layer is an acrylic pressure-sensitive adhesive.

Effects of Invention

According to an aspect of the semiconductor processing tape of the present invention, the substrate film is a cured product of an epoxy compound-containing composition and a thermal shrinkage ratio after retention under an atmosphere at 260°C for 10 minutes, of the semiconductor processing tape, is 5.0% or less, and therefore heat shrinkage of the semiconductor processing tape can be prevented even under the heating atmosphere of a reflow step and the semiconductor processing tape can be prevented from being dropped out and peeled from a ring frame. Accordingly, the semiconductor processing tape of the present invention has excellent heat resistance even under the heating atmosphere of a reflow step. In addition, according to an aspect of the semiconductor processing tape of the present invention, a thermal shrinkage ratio after retention under an atmosphere at 260°C for 10 minutes, of the semiconductor processing tape, is 5.0% or less, and therefore it is possible to prevent peeling of the semiconductor processing tape, from a board, even under an atmosphere at 260°C.

From the foregoing, the semiconductor processing tape of the present invention can be used as a support (carrier) in a reflow step, and can also be used as a dicing tape for use in a dicing step, thereby enabling a reflow step and a dicing step to be simplified.

When semiconductor chips are picked up, such semiconductor chips may be picked up after an expanding step of expanding a semiconductor processing tape in order to widen the interval between such semiconductor chips, and, according to an aspect of the semiconductor processing tape of the present invention, a fracture elongation under an atmosphere at 23°C, of the semiconductor processing tape, is 15% or more, and therefore flexibility under an atmosphere at 23°C can be further imparted to more smoothen an expanding step and certainly pick up semiconductor chips. Accordingly, since the fracture elongation under an atmosphere at 23°C is 15% or more, the degree of freedom of selection of a pickup procedure increases.

According to an aspect of the semiconductor processing tape of the present invention, a fracture elongation after retention under an atmosphere at 260°C for 10 minutes, of the semiconductor processing tape, is 15% or more, and therefore flexibility after passage through an atmosphere at 260°C can be further imparted to more smoothen an expanding step and certainly pick up semiconductor chips even after application of the semiconductor processing tape to a reflow step. Accordingly, since the fracture elongation after retention under an atmosphere at 260°C for 10 minutes is 15% or more, the degree of freedom of selection of a pickup procedure increases.

According to an aspect of the semiconductor processing tape of the present invention, a tensile elastic modulus under an atmosphere at 260°C, of the semiconductor processing tape, is 0.5 MPa or more, and therefore the semiconductor processing tape, attached to a ring frame, can be prevented from warping in a reflow step due to the load of a device or the like mounted on the semiconductor processing tape. Accordingly, since the tensile elastic modulus under an atmosphere at 260°C, of the semiconductor processing tape, is 0.5 MPa or more, it is possible to prevent the semiconductor processing tape from contacting with a site of a reflow furnace located below a ring frame in a direction of gravitational force.

According to an aspect of the semiconductor processing tape of the present invention, the epoxy compound-containing composition has at least two kinds of epoxy compounds and the two kinds of epoxy compounds are an epoxy compound having a cyclic hydrocarbon structure and an epoxy compound not having a cyclic hydrocarbon structure, and therefore it is possible to certainly enhance heat resistance.

According to an aspect of the semiconductor processing tape of the present invention, the epoxy compound-containing composition includes a film-forming agent and a crosslinking component composed of an epoxy compound and a blending proportion of the crosslinking component composed of an epoxy compound to a total amount of the film-forming agent and the crosslinking component composed of an epoxy compound is 20% by mass or more and 80% by mass or less, and therefore it is possible to enhance heat resistance and flexibility under an atmosphere at 260°C in a well-balanced manner.

Description of Embodiments

The semiconductor processing tape of the present invention is a semiconductor processing tape, in which a pressure-sensitive adhesive layer is formed on a substrate film. The semiconductor processing tape of the present invention can be used in, for example, a heating step at 200°C or more. Examples of the heating step at 200°C or more include a reflow step as a heating step at about 260°C. The substrate film is a cured product of an epoxy compound-containing composition. Examples of the cured product of an epoxy compound-containing composition include a thermally cured product of an epoxy compound-containing composition.

The semiconductor processing tape of the present invention includes a sheet-shaped substrate film as a cured product of an epoxy compound-containing composition, and a pressure-sensitive adhesive layer formed on at least one surface of the substrate film. The thermal shrinkage ratio after retention under an atmosphere at 260°C for 10 minutes, of the semiconductor processing tape, is controlled to 5.0% or less.

The thermal shrinkage ratio after retention under an atmosphere at 260°C for 10 minutes is 5.0% or less in the semiconductor processing tape of the present invention, and therefore heat shrinkage of the semiconductor processing tape can be prevented even under the heating atmosphere of a reflow step to prevent the semiconductor processing tape from being dropped out and peeled from a ring frame. Accordingly, the semiconductor processing tape of the present invention has excellent heat resistance even under the heating atmosphere of a reflow step. The thermal shrinkage ratio after retention under an atmosphere at 260°C for 10 minutes is 5.0% or less in the semiconductor processing tape of the present invention, and therefore it is possible to prevent peeling of the semiconductor processing tape, from a board, even under an atmosphere at 260°C.

From the foregoing, the semiconductor processing tape of the present invention can be used as a support (carrier) in a reflow step and also as a dicing tape in a dicing step after such a reflow step, thereby enabling such reflow step and dicing step to be simplified.

The thermal shrinkage ratio after retention under an atmosphere at 260°C for 10 minutes, of the semiconductor processing tape, is not particularly limited as long as it is 5.0% or less, and is preferably 3.0% or less, particularly preferably 1.0% or less from the viewpoint of certainly preventing heat shrinkage of the semiconductor processing tape and peeling thereof from a board even under the heating atmosphere of a reflow step. Here, the lower limit value of the thermal shrinkage ratio after retention under an atmosphere at 260°C for 10 minutes, of the semiconductor processing tape, is, for example, 0.1%.

The thermal shrinkage ratio after retention under an atmosphere at 260°C for 10 minutes, of the semiconductor processing tape, can be regulated by adjusting the compositional ratio of an epoxy compound-containing composition described below.

When semiconductor chips are picked up, such semiconductor chips may be picked up after an expanding step of expanding the semiconductor processing tape in order to widen the interval between such semiconductor chips. From the foregoing, the fracture elongation under an atmosphere at 23°C, of the semiconductor processing tape, is not particularly limited, and the lower limit value is preferably 15%, more preferably 20%, particularly preferably 30% from the viewpoint that flexibility under an atmosphere at 23°C can be further imparted to more smoothen an expanding step and certainly pick up semiconductor chips. Accordingly, by the fracture elongation under an atmosphere at 23°C being 15% or more, the degree of freedom of selection of a pickup procedure increases. In this regard, the upper limit value of the fracture elongation under an atmosphere at 23°C, of the semiconductor processing tape, is more preferred as it is higher, and is, for example, 200%. Here, the fracture elongation under an atmosphere at 23°C is a tensile fracture elongation measured by performing a tensile test of a test piece at a test speed of 200 mm/min under an environment of 23°C and a humidity of 50% according to JIS K7127.

The fracture elongation under an atmosphere at 23°C, of the semiconductor processing tape, can be regulated by adjusting the compositional ratio of an epoxy compound-containing composition described below, in particular, adjusting the amount of an epoxy compound blended in such an epoxy compound-containing composition.

The fracture elongation after retention under an atmosphere at 260°C for 10 minutes, of the semiconductor processing tape, is not particularly limited, but the lower limit value is preferably 15%, more preferably 20%, particularly preferably 30% from the viewpoint that flexibility after passage through an atmosphere at 260°C can be further imparted to more smoothen an expanding step and certainly pick up semiconductor chips even after application of the semiconductor processing tape to a reflow step. Accordingly, the fracture elongation after retention under an atmosphere at 260°C for 10 minutes is 15% or more, and therefore the degree of freedom of selection of a pickup procedure increases. In this regard, the upper limit value of the fracture elongation after retention under an atmosphere at 260°C for 10 minutes, of the semiconductor processing tape, is more preferred as it is higher, and is, for example, 200%. Here, the fracture elongation after retention under an atmosphere at 260°C for 10 minutes is a tensile fracture elongation measured by performing solder reflow heating under an atmosphere at 260°C for 10 minutes according to IPC/JEDEC J-STD-020 Revision D.1 and then performing a tensile test of a test piece at a test speed of 200 mm/min under an environment of 23°C and a humidity of 50% according to JIS K7127.

The fracture elongation after retention under an atmosphere at 260°C for 10 minutes, of the semiconductor processing tape, can be regulated by adjusting the compositional ratio of an epoxy compound-containing composition described below, in particular, adjusting the amount of an epoxy compound blended in such an epoxy compound-containing composition.

The tensile elastic modulus under an atmosphere at 260°C, of the semiconductor processing tape, is not particularly limited, and the lower limit value thereof is preferably 0.5 MPa, more preferably 1.0 MPa, further preferably 2.0 MPa, particularly preferably 5.0 MPa from the viewpoint that it is possible to prevent the semiconductor processing tape, attached to a ring frame, from warping in a reflow step due to the load of a device or the like mounted on the semiconductor processing tape. Accordingly, the tensile elastic modulus under an atmosphere at 260°C, of the semiconductor processing tape, is 0.5 MPa or more, and therefore it is possible to prevent the semiconductor processing tape from contacting with a site of a reflow furnace located below a ring frame in a direction of gravitational force. In this regard, the upper limit value of the tensile elastic modulus under an atmosphere at 260°C, of the semiconductor processing tape, is preferably 70 MPa, particularly preferably 50 MPa from the viewpoint of preventing the stress to be applied in deformation of the semiconductor processing tape from increasing to certainly prevent the semiconductor processing tape from being peeled from a ring frame in picking up of semiconductor chips. Here, the tensile elastic modulus under an atmosphere at 260°C is a tensile elastic modulus measured according to the dynamic viscoelasticity measurement method of JIS K7244.

The tensile elastic modulus under an atmosphere at 260°C, of the semiconductor processing tape, can be regulated by adjusting the compositional ratio of an epoxy compound-containing composition described below, in particular, adjusting the amount of an epoxy compound blended in such an epoxy compound-containing composition.

Next, each component of an epoxy compound-containing composition is described. The epoxy compound-containing composition includes (A) a film-forming agent for obtaining film properties such as properties of the substrate film, (B) a crosslinking component composed of an epoxy compound, which imparts heat resistance due to curing of the epoxy compound-containing composition, and (C) a curing agent.

(A) Film-forming agent

The film-forming agent is mainly a component for imparting plasticity to the substrate film. The film-forming agent is a binder component of the substrate film. Examples of the film-forming agent include a (meth)acrylic polymer, an epoxy polymer such as a phenoxy resin, and a silicone resin. Among these, a phenoxy resin is preferred from the viewpoint of being excellent in compatibility with a crosslinkable component.

Examples of the phenoxy resin include a product increased in molecular weight, of biphenols such as bisphenol A and bisphenol F, a copolymer of bisphenol F and 1,6-hexanediol diglycidyl ether, a copolymer of 1,6-hexanediol and bisphenol F diglycidyl ether, a copolymer of bisphenol F and 1,4-butanediol diglycidyl ether, a copolymer of 1,4-butanediol and bisphenol F diglycidyl ether, a copolymer of bisphenol A and 1,6-hexanediol diglycidyl ether, a copolymer of 1,6-hexanediol and bisphenol A diglycidyl ether, a copolymer of bisphenol A and 1,4-butanediol diglycidyl ether, a copolymer of 1,4-butanediol and bisphenol A diglycidyl ether, a copolymer of tetramethyl biphenol and 1,6-hexanediol diglycidyl ether, a copolymer of 1,6-hexanediol and tetramethyl biphenol diglycidyl ether, a copolymer of tetramethyl biphenol and 1,4-butanediol diglycidyl ether, a copolymer of 1,4-butanediol and tetramethyl biphenol diglycidyl ether, a copolymer of biphenol and 1,6-hexanediol diglycidyl ether, a copolymer of 1,6-hexanediol and biphenol diglycidyl ether, a copolymer of biphenol and 1,4-butanediol diglycidyl ether, a copolymer of 1,4-butanediol and biphenol diglycidyl ether, a copolymer of 1,4-naphthalenediol and 1,6-hexanediol diglycidyl ether, a copolymer of 1,6-hexanediol and 1,4-naphthalenediol diglycidyl ether, a copolymer of 1,4-naphthalenediol and 1,4-butanediol diglycidyl ether, a copolymer of 1,4-butanediol and 1,4-naphthalenediol diglycidyl ether, a copolymer of 1,6-naphthalenediol and 1,6-hexanediol diglycidyl ether, a copolymer of 1,6-hexanediol and 1,6-naphthalenediol diglycidyl ether, a copolymer of 1,6-naphthalenediol and 1,4-butanediol diglycidyl ether, and a copolymer of 1,4-butanediol and 1,6-naphthalenediol diglycidyl ether. These epoxy polymers may be used singly or in combinations of two or more thereof.

It is preferable from the viewpoint of certainly contributing to flexibility and heat resistance (decomposition resistance under an atmosphere at 260°C) of the substrate film to use a copolymer of bisphenol F and 1,6-hexanediol diglycidyl ether, and a product increased in molecular weight, of bisphenols, in combination, among these phenoxy resins.

(B) Crosslinking component composed of epoxy compound

The crosslinking component composed of an epoxy compound is a component for imparting heat resistance to the substrate film, namely, reducing the thermal shrinkage ratio after retention under an atmosphere at 260°C for 10 minutes. From the foregoing, the crosslinking component composed of an epoxy compound is a component for imparting heat resistance, namely, reducing the thermal shrinkage ratio after retention under an atmosphere at 260°C for 10 minutes, in the form of the semiconductor processing tape. Examples of the epoxy compound constituting the crosslinking component include epoxy compounds each having a cyclic hydrocarbon structure, such as bisphenol A glycidyl ether, a bisphenol A-type epoxy resin, bisphenol F glycidyl ether, a bisphenol F-type epoxy resin, a phenol novolac-type epoxy resin, and an alicyclic epoxy resin, and epoxy compounds each not having a cyclic hydrocarbon structure, such as glycidyl ether of an aliphatic structure and an epoxy resin of an aliphatic structure.

Among these epoxy compounds, a bi- or higher-functional epoxy compound having two or more epoxy groups is preferred from the viewpoint of not only imparting heat resistance to the semiconductor processing tape, but also enhancing the tensile elastic modulus to enhance the function of a support.

Examples of the bifunctional epoxy compound include bisphenol-based diglycidyl ethers such as bisphenol A diglycidyl ether, bisphenol F diglycidyl ether, bisphenol E diglycidyl ether, bisphenol Z diglycidyl ether, bisphenol S diglycidyl ether, bisphenol AD diglycidyl ether, bisphenol acetophenone diglycidyl ether, bisphenol trimethylcyclohexane diglycidyl ether, bisphenol fluorene diglycidyl ether, tetramethyl bisphenol A diglycidyl ether, tetramethyl bisphenol F diglycidyl ether, tetra-t-butyl bisphenol A diglycidyl ether, and tetramethyl bisphenol S diglycidyl ether; biphenol-based diglycidyl ethers such as biphenol diglycidyl ether, tetramethyl biphenol diglycidyl ether, dimethyl biphenol diglycidyl ether, and tetra-t-butyl biphenol diglycidyl ether; benzenediol-based diglycidyl ethers such as hydroquinone diglycidyl ether, dihydroanthracene diglycidyl ether, methylhydroquinone diglycidyl ether, dibutylhydroquinone diglycidyl ether, resorcinol diglycidyl ether, and methylresorcinol diglycidyl ether; aromatic diglycidyl ethers such as dihydroanthrahydroquinone diglycidyl ether, dihydroxydiphenyl ether diglycidyl ether, thiodiphenol diglycidyl ether, and dihydroxynaphthalene diglycidyl ether; epoxy compounds in which hydrogen is added to aromatic rings of diglycidyl ethers selected from the group consisting of the bisphenol-based diglycidyl ethers, the biphenol-based diglycidyl ethers, the benzenediol-based diglycidyl ethers and the aromatic diglycidyl ethers; epoxy resins produced from carboxylic acids such as adipic acid, succinic acid, phthalic acid, tetrahydrophthalic acid, methylhexahydrophthalic acid, terephthalic acid, isophthalic acid, ortho-phthalic acid, biphenyldicarboxylic acid and dimer acid, and epihalohydrin; (poly)alkylene glycol diglycidyl ethers each composed of only a chain structure (namely, not having a cyclic hydrocarbon structure), such as ethylene glycol diglycidyl ether, polyethylene glycol diglycidyl ether, propylene glycol diglycidyl ether, polypropylene glycol diglycidyl ether, 1,4-butanediol diglycidyl ether, polytetramethylene glycol diglycidyl ether, 1,5-pentanediol diglycidyl ether, polypentamethylene glycol diglycidyl ether, 1,6-hexanediol diglycidyl ether, polyhexamethylene glycol diglycidyl ether, 1,7-heptanediol diglycidyl ether, polyheptamethylene glycol diglycidyl ether, 1,8-octanediol diglycidyl ether, 1,10-decanediol diglycidyl ether, and 2,2-dimethyl-1,3-propanediol diglycidyl ether; alkylene glycol diglycidyl ethers each having an alicyclic structure, such as 1,4-cyclohexanedimethanol diglycidyl ether, and diglycidyl ethers each having an elastomeric backbone (namely, diglycidyl ethers each not having a cyclic hydrocarbon structure), such as polybutadiene.

Among these, the epoxy compound-containing composition preferably includes at least two kinds of epoxy compounds, as the crosslinking component, from the viewpoint of imparting to the semiconductor processing tape, not only heat resistance, but also excellent flexibility, and particularly preferably includes an epoxy compound having a cyclic hydrocarbon structure and an epoxy compound not having a cyclic hydrocarbon structure from the viewpoint that it is possible to certainly enhance heat resistance.

Among these, the epoxy compound-containing composition preferably includes an epoxy compound having an elastomeric backbone and an epoxy compound not having an elastomeric backbone from the viewpoint of not only certainly enhancing heat resistance, but also imparting excellent flexibility, and particularly preferably includes an epoxy compound having a cyclic hydrocarbon structure, and an epoxy compound having an elastomeric backbone as an epoxy compound not having a cyclic hydrocarbon structure.

The blending proportion of the crosslinking component composed of an epoxy compound, based on the total amount (100% by mass) of the film-forming agent and the crosslinking component composed of an epoxy compound, is not particularly limited, and the lower limit value thereof is preferably 20% by mass from the viewpoint of enabling the thermal shrinkage ratio after retention under an atmosphere at 260°C for 10 minutes, of the semiconductor processing tape, to be more certainly controlled to 5.0% or less, namely, certainly achieving heat resistance, more preferably 30% by mass from the viewpoint of enhancing the tensile elastic modulus to certainly achieve the function of a support, and further preferably 40% by mass, particularly preferably 45% by mass from the viewpoint of further enhancing the tensile elastic modulus to enhance the function of a support. In this regard, the upper limit value of the blending proportion of the crosslinking component composed of an epoxy compound, based on the total amount (100% by mass) of the film-forming agent and the crosslinking component composed of an epoxy compound, is preferably 80% by mass, more preferably 70% by mass from the viewpoint of allowing flexibility under an atmosphere at 23°C and flexibility after passage through an atmosphere at 260°C to be obtained, and is further preferably 60% by mass, particularly preferably 55% by mass from the viewpoint of allowing flexibility under an atmosphere at 23°C and flexibility after passage through an atmosphere at 260°C to be further enhanced.

(C) Curing agent

The curing agent is a component contributing to a crosslinking reaction between an epoxy group of the above epoxy compound, and a functional group having reactivity with the epoxy group. The type of the curing agent is not particularly limited, and any compound is usable as long as it is a compound usable as a curing agent of the epoxy compound such as an epoxy resin.

Examples of the curing agent include phenols, amines such as tertiary amine, aliphatic amine, polyetheramine, alicyclic amine and aromatic amine, acid anhydrides, amides, imidazoles, organic phosphines, phosphonium salts, aromatic sulfonium salts, tetraphenylboron salts, organic acid dihydrazides, boron halide-amine complexes, polymercaptans, isocyanates, and block isocyanates.

The amount of the curing agent blended is not particularly limited, and is preferably 0.1 parts by mass or more and 10 parts by mass or less, particularly preferably 1.0 part by mass or more and 5 parts by mass or less based on a total amount of 100 parts by mass of the film-forming agent and the crosslinking component composed of an epoxy compound.

An optional component may be, if necessary, appropriately blended, in addition to the component (A) to the component (C), in the epoxy compound-containing composition, depending on use conditions or the like of the semiconductor processing tape. Examples of the optional component include an inorganic filler and an organic filler.

The inorganic filler is blended to contribute to an enhancement in tensile elastic modulus under an atmosphere at 260°C. Examples of the inorganic filler include metal oxides such as aluminum oxide and magnesium oxide, metal carbonates such as calcium carbonate and magnesium carbonate, silicon compounds such as diatomaceous earth powder, basic magnesium silicate, baked clay, fine powder silica, molten silica, and zeolite, metal hydroxides such as aluminum hydroxide, kaolin, mica, quartz powder, graphite, carbon black, carbon nanotube, molybdenum disulfide, boron nitride, and aluminum nitride. These inorganic fillers may be used singly or in combinations of two or more thereof. Examples of the shape of the inorganic filler include a powdery shape and a particulate shape.

In a case where an inorganic filling material is blended in the epoxy compound-containing composition, it is preferable to blend the material so that the tensile elastic modulus under an atmosphere at 260°C, of the semiconductor processing tape, is 0.5 MPa or more. From the foregoing, the upper limit value of the amount of the inorganic filler blended is preferably 450 parts by mass, more preferably 100 parts by mass, particularly preferably 30 parts by mass based on a total amount of 100 parts by mass of the film-forming agent and the crosslinking component composed of an epoxy compound. In this regard, the lower limit value of the amount of the inorganic filler blended is preferably 0.5 parts by mass, particularly preferably 5.0 parts by mass based on a total amount of 100 parts by mass of the film-forming agent and the crosslinking component composed of an epoxy compound.

The organic filler is blended to contribute to an enhancement in flexibility of the substrate film. Examples of the organic filler include a curable monomer, an oligomer, and a synthetic resin. More specific examples of the organic filler include a cyanate ester resin, a (meth)acrylic resin, a silicone resin, and a polyester resin. These organic fillers may be used singly or in combinations of two or more thereof. Examples of the shape of the organic filler include a powdery shape and a particulate shape.

In a case where an organic filling material is blended in the epoxy compound-containing composition, the upper limit value of the amount of the organic filling material blended is 25 parts by mass based on a total amount of 100 parts by mass of the film-forming agent and the crosslinking component composed of an epoxy compound from the viewpoint of allowing moldability of the epoxy compound-containing composition to be certainly kept. In this regard, the lower limit value of the amount of the organic filling material blended is preferably 0.5 parts by mass based on a total amount of 100 parts by mass of the film-forming agent and the crosslinking component composed of an epoxy compound from the viewpoint of contribution to an enhancement in flexibility of the substrate film.

A solvent may be, if necessary, appropriately blended as the optional component, in addition to the component (A) to the component (C), in the epoxy compound-containing composition. The solvent is a component for adjusting coatability, viscosity, dispersibility, and/or the like of the epoxy compound-containing composition. Examples of the solvent include an organic solvent, and specific examples thereof include methyl ethyl ketone, toluene, cyclohexanone, and cyclohexane.

Next, the pressure-sensitive adhesive layer is described. The pressure-sensitive adhesive layer is formed on at least one surface of the substrate film, thereby not only having the function of allowing a device such as a semiconductor wafer to firmly adhere to the semiconductor processing tape, but also having the function of enabling semiconductor chips or the like individuated after dicing of a device such as a semiconductor wafer to be released without any adhesive residue.

Here, the pressure-sensitive adhesive layer formed on the substrate film has almost no effect on the thermal shrinkage ratio, the fracture elongation, and the tensile elastic modulus, as compared with the substrate film, and thus the substrate film has a thermal shrinkage ratio in the above range, a fracture elongation in the above range and a tensile elastic modulus in the above range, to enable the semiconductor processing tape of the present invention to have a thermal shrinkage ratio in the above range, a fracture elongation in the above range and a tensile elastic modulus in the above range.

The pressure-sensitive adhesive constituting the pressure-sensitive adhesive layer of the semiconductor processing tape is not particularly limited, known one can be used, and examples include (meth)acrylic, silicone-based, polyester-based, allyl-based, and fluorine-based pressure-sensitive adhesives. Among these, a (meth)acrylic pressure-sensitive adhesive is preferred from the viewpoints of being excellent in heat resistance and of being easily adjusted with respect to pressure-sensitive adhesive force, and an acrylic pressure-sensitive adhesive is particularly preferred from the viewpoint of contamination control of semiconductor chips and the like after a dicing step.

Examples

Next, Examples of the present invention are described, but the present invention is not limited to the following Examples.

Examples 1 to 11

Production of semiconductor processing tape

Each component shown in Table 1 below was dissolved in methyl ethyl ketone at a proportion shown in Table 1 below, to obtain an epoxy compound-containing composition. The epoxy compound-containing composition obtained was applied with a comma coater, then dried at 130°C for 3 minutes, thereafter heated at 110°C for 3 hours, and subjected to thermal curing treatment, to obtain a substrate film (100 μm). Thereafter, a pressure-sensitive adhesive shown in Table 1 below was applied on a separator made of polyethylene terephthalate, and dried at 110°C for 3 minutes, to form a pressure-sensitive adhesive layer of 20 μm on the separator. Thereafter, the pressure-sensitive adhesive layer was pasted on the substrate film, and aged at 40°C for one week, and the separator made of polyethylene terephthalate was released to produce a semiconductor processing tape.

Comparative Examples 1 to 4

Each semiconductor processing tape was produced in the same manner as in Examples 1 to 11 except that each component shown in Table 2 below was dissolved in methyl ethyl ketone at a proportion shown in Table 2 below, to obtain an epoxy compound-containing composition.

The detail of each component in Table 1 and Table 2 is as follows. Here, the blending proportion of each component in Table 1 and Table 2 means one expressed by part(s) by mass, unless particularly noted.

<Film-forming agent>

• Film-forming agent 1: phenoxy resin (product increased in molecular weight of bisphenol A)

Product increased in molecular weight of bisphenol A

YP-50 (manufactured by Nippon Steel Chemical & Material Co., Ltd.)

• Film-forming agent 2: phenoxy resin (copolymer of bisphenol F and 1,6-hexanediol diglycidyl ether)

Method for synthesizing copolymer of bisphenol F and 1,6-hexanediol diglycidyl ether
A 1-L glass flask equipped with a stirrer, a dripping funnel and a thermometer was charged with 141.8 parts by mass of 1,6-hexanediol and 0.51 parts by mass of boron trifluoride ethyl ether heated to 45°C in advance, and heated to 80°C. Thereto was dripped 244.3 parts by mass of epichlorohydrin over time so that the temperature did not reach 85°C or more. After aging for 1 hour at 80 to 85°C retained, the resultant was cooled to 45°C. Thereto was added 528.0 parts by mass of an aqueous 22% by mass sodium hydroxide solution, and vigorously stirred at 45°C for 4 hours. The resultant was cooled to room temperature to separate and remove an aqueous phase, and heated under reduced pressure to remove unreacted epichlorohydrin and water, to obtain 283.6 parts by mass of crude 1,6-hexanediol diglycidyl ether. This crude 1,6-hexanediol diglycidyl ether was filtered and purified in an oldershaw distillation column (15 stages), and a fraction at a pressure of 1300 Pa and 170 to 190°C was taken as a main fraction, to obtain 127.6 parts by mass of 1,6-hexanediol diglycidyl ether in which the purity of a diglycidyl form was 97% by mass, the total amount of chlorine was 0.15% by mass and the epoxy equivalent was 116 g/eq, according to a gas chromatographic method. A pressure-resistant reaction vessel was loaded with 100 parts by mass of the 1,6-hexanediol diglycidyl ether, 69.3 parts by mass of bisphenol F (phenolic hydroxyl equivalent: 100 g/eq), and 0.13 parts by mass of ethyltriphenylphosphonium iodide (30% by mass solution in methyl cellosolve), and a polymerization reaction was performed under a nitrogen gas atmosphere at 165 to 170°C for 5 hours, to obtain a copolymer of bisphenol F and 1,6-hexanediol diglycidyl ether, in which the epoxy equivalent was 1,000 g/eq and the number average molecular weight was 3,000.

<Crosslinking component composed of epoxy compound>

· Crosslinking component composed of epoxy compound 1: bisphenol A-type epoxy resin (Mitsubishi Chemical Corporation, "jER828", epoxy equivalent: 390 g/eq)
· Crosslinking component composed of epoxy compound 2: diglycidyl ether having elastomeric backbone of polybutadiene
· Crosslinking component composed of epoxy compound 3: polytetramethylene glycol diglycidyl ether (epoxy equivalent: 440 g/eq)
· Crosslinking component composed of epoxy compound 4: alicyclic epoxy resin (Daicel Corporation, "Celloxide 2021P")

<Curing agent>

• SI-80L: sulfonium salt derivative (Sanshin Chemical Industry Co., Ltd.)
• Alicyclic polyamine: ADEKA Corporation, "EH-5057EK"

<Optional component>

• LA4285: acrylic rubber (Kuraray Co., Ltd.)

<Pressure-sensitive adhesive>

The detail of a preparation method of each pressure-sensitive adhesive used in Examples 1 to 11 and Comparative Examples 1 to 4 is as follows.

· Pressure-sensitive adhesive with acrylic base polymer

A reaction vessel equipped with a cooling tube, a nitrogen introduction tube, a thermometer and a stirring apparatus was loaded with 100 parts by mass of butyl acrylate, 8 parts by mass of acrylic acid, 0.3 parts by mass of azobisisobutyronitrile, and 60 parts by mass of ethyl acetate, and polymerization treatment was conducted in a nitrogen stream at 65°C for 6 hours, to prepare an acrylic base polymer. In 100 parts by mass of the resulting acrylic base polymer was blended 1 part by mass of a curing agent ("tetrad C", polyfunctional epoxy resin, Mitsubishi Gas Chemical Company, Inc.), to prepare a pressure-sensitive adhesive.

· Pressure-sensitive adhesive with silicone-based base polymer

With 100 parts by mass of polysiloxane ("KR-3700", Shin-Etsu Chemical Co., Ltd.) were mixed 0.3 parts by mass of dimethyldi-n-decylammonium-tetrafluoroboronate, 5 parts by mass of an allyl alcohol-ethylene oxide adduct, 0.5 parts by mass of a platinum-group metal-based catalyst (curing agent, "CAT-PL-50T", Shin-Etsu Chemical Co., Ltd.), 0.3 parts by mass of an antioxidant ("Adekastab AO-60G", ADEKA Corporation) and 110 parts by mass of toluene, to prepare a pressure-sensitive adhesive.

· Pressure-sensitive adhesive with polyester-based base polymer

A reaction can equipped with a thermometer, a stirrer, a rectification column, and a nitrogen introduction tube was charged with 495 parts by mass (0.9 mol) of sebacic acid and 45 parts by mass (0.1 mol) of isophthalic acid as divalent carboxylic acids, 283 parts by mass (1 mol) of neopentyl glycol and 64 parts by mass (0.2 mol) of 1,6-hexanediol as polyols, and 0.3 parts of tetrabutyl titanate as a catalyst, and the temperature was raised over 2 hours until the inner temperature reached 260°C, to perform an esterification reaction at 260°C for 3 hours. Thereafter, the inner temperature was dropped to 170°C, 113 parts by mass (0.19 mol) of pyromellitic acid anhydride was added as an acid anhydride of tri- or higher valent carboxylic acid, to perform a chain extension reaction for 1 hour, thereby preparing a polyester-based base polymer. The weight average molecular weight of the polyester-based base polymer obtained was 28,900, the glass transition temperature (Tg) thereof was -32°C, and the acid value thereof was 70.1 mgKOH/g. To 100 parts by mass of the solid content of the resulting polyester-based base polymer solution were blended 5 parts by mass of an epoxy-based crosslinking agent (curing agent, Mitsubishi Gas Chemical Company, Inc., "tetrad X") and 0.1 parts by mass of a hindered phenol-based antioxidant (BASF SE, "IRGANOX 1010"), to prepare a pressure-sensitive adhesive.

Evaluation items

(1) Thermal shrinkage ratio

After the separator was released, the pressure-sensitive adhesive layer was mutually pasted to obtain a sample for evaluation of a configuration of substrate film/pressure-sensitive adhesive layer/substrate film. The sample for evaluation was sandwiched by glass, and left to still stand at 260°C for 10 minutes, and the thermal shrinkage ratio was calculated by the following expression. Marked line distance before heating (100-mm basis): X, marked line distance after heating: Y

$$\text{Thermal shrinkage ratio (\%)} = (X - Y)/X$$

(2) Tape peeling

The peeled state of the semiconductor processing tape from a board after solder reflow heating performed under an atmosphere at 260°C for 10 minutes according to IPC/JEDECJ-STD-020 Revision D.1 was observed with the naked eye, and was evaluated according to the following criteria.

    Good: no floating of the semiconductor processing tape
    Fair: floating occurring on any edge of the semiconductor processing tape
    Poor: floating occurring on the whole of the semiconductor processing tape

(3) Fracture elongation at ordinary temperature

After the separator was released, the semiconductor processing tape was cut out to 15 mm width × 150 mm length, to provide a test piece. A tensile test of the test piece was performed at a test speed of 200 mm/min under an environment of 23°C and 50% according to JIS K7127, and the elongation at tensile fraction in the tensile test was defined as the fracture elongation at ordinary temperature.

(4) Fracture elongation after heating

After the separator was released, solder reflow heating under an atmosphere at 260°C for 10 minutes was performed according to IPC/JEDECJ-STD-020 Revision D.1, and thereafter the semiconductor processing tape was cut out to 15 mm width × 150 mm length, to provide a test piece. A tensile test of the test piece was performed at a test speed of 200 mm/min under an environment of 23°C and a humidity of 50% according to JIS K7127, and the elongation at tensile fraction in the tensile test was defined as the fracture elongation after heating.

(5) Tensile elastic modulus

Measurement was performed by a dynamic viscoelasticity measurement method described in JIS K7244, with a dynamic viscoelasticity measurement apparatus (ITK Co., Ltd., "DVA-200") at a frequency of 1 Hz and a rate of temperature rise of 3°C/min in a measurement condition of a mode of tensile at both ends, to determine the tensile elastic modulus at 260°C.

(6) Residue after peeling

The presence of any residue of a pressure-sensitive adhesive after picking up of a sample from the semiconductor processing tape, and releasing, was observed with a microscope (magnification 100x), and was evaluated according to the following criteria.

Good: no residue of pressure-sensitive adhesive
Fair: slight residue of pressure-sensitive adhesive, but such residue removable by washing
Poor : much residue of pressure-sensitive adhesive, and such residue remaining even by washing

The evaluation results are shown in Tables 1 and 2 below.

[Table 1]

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| Epoxy compound-containing composition | Film-forming agent 1 | 15 | 25 | 25 | 35 | 25 | 15 | 25 | 35 | 25 | 25 | 25 |
| | Film-forming agent 2 | 15 | 25 | 25 | 35 | 25 | 15 | 25 | 35 | 25 | 25 | 25 |
| | Crosslinking component composed of epoxy compound 1 | 14 | 10 | 25 | 6 | 10 | 14 | 10 | 6 | 0 | 10 | 10 |
| | Crosslinking component composed of epoxy compound 2 | 56 | 40 | 25 | 24 | 20 | 0 | 0 | 0 | 40 | 40 | 40 |
| | Crosslinking component composed of epoxy compound 3 | 0 | 0 | 0 | 0 | 0 | 56 | 40 | 24 | 0 | 0 | 0 |
| | Crosslinking component composed of epoxy compound 4 | 0 | 0 | 0 | 0 | 0 | 0 | 0 | 0 | 10 | 0 | 0 |
| | Curing agent (SI-80L) | 2,1 | 1,5 | 1,5 | 0,9 | 0,9 | 2,1 | 1,5 | 0,9 | 1,5 | 1,5 | 1,5 |
| | Optional component (LA4285) | 0 | 0 | 0 | 0 | 10 | 0 | 0 | 0 | 0 | 0 | 0 |
| Compositional ratio of pressure-sensitive adhesive | Base polymer | Acrylic | Acrylic | Acrylic | Acrylic | Acrylic | Acrylic | Acrylic | Acrylic | Acrylic | Silicone-based | Polyester-based |
| | | 100 | 100 | 100 | 100 | 100 | 100 | 100 | 100 | 100 | 100 | 100 |
| | Curing agent | tetradC | tetradC | tetradC | tetradC | tetradC | tetradC | tetradC | tetradC | tetradC | TCAT-PL-50T | Tetrad X |
| | | 1 | 1 | 1 | 1 | 1 | 1 | 1 | 1 | 1 | 0,5 | 5 |
| Evaluation results | Thermal shrinkage ratio | 0,3% | 0,3% | 0,2% | 2,0% | 0,2% | 0,4% | 0,8% | 3,5% | 0,3% | 0,2% | 0,2% |
| | Tape peeling | Good | Good | Good | Fair | Good | Good | Good | Fair | Good | Good | Good |
| | Fracture elongation at ordinary temperature | 19% | 100% | 75% | 130% | 110% | 35% | 75% | 90% | 100% | 100% | 100% |

(continued)

|  | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|
| Fracture elongation after heating | 17% | 90% | 65% | 100% | 95% | 25% | 70% | 80% | 90% | 95% | 95% |
| Tensile elastic modulus (260°C) | 50MPa | 7MPa | 9MPa | 0.9MPa | 8MPa | 21MPa | 5MPa | 0.8MPa | 8MPa | 7MPa | 7MPa |
| Residue after releasing | Good | Good | Good | Good | Good | Good | Good | Good | Good | Fair | Fair |

[Table 2]

| | | Comparative Example 1 | Comparative Example 2 | Comparative Example 3 | Comparative Example 4 |
|---|---|---|---|---|---|
| Epoxy compound-containing composition | Film-forming agent 1 | 0 | 0 | 0 | 45 |
| | Film-forming agent 2 | 100 | 50 | 50 | 45 |
| | Crosslinking component composed of epoxy compound 1 | 0 | 50 | 50 | 5 |
| | Crosslinking component composed of epoxy compound 2 | 0 | 0 | 0 | 5 |
| | Curing agent | - | SI-80L | Alicyclic polvamine | SI-80L |
| | | | 1,5 | 15,2 | 1,5 |
| | Optional component | - | - | - | - |
| | | | | | |
| Compositional ratio of pressure-sensitive adhesive | Base polymer | Acrylic | Acrylic | Acrylic | Acrylic |
| | | 100 | 100 | 100 | 100 |
| | Curing agent | tetradC | tetradC | tetradC | tetradC |
| | | 1 | 1 | 1 | 1 |
| Evaluation results | Thermal shrinkage ratio | 10,0% | 6,0% | 6,0% | 7,0% |
| | Tape peeling | Poor | Poor | Poor | Poor |
| | Fracture elongation at ordinary temperature | 200% | 120% | 110% | 170% |
| | Fracture elongation after heating | Molten | 100% | 100% | Molten |
| | Tensile elastic modulus | Molten | 0.1MPa | 0.1MPa | Molten |
| | (260°C) Residue after releasing | Molten | Good | Good | Molten |

It was found as shown in Tables 1 and 2 that, in each of the tapes for semiconductor processing of Examples 1 to 11 in which the substrate film was a cured product of an epoxy compound-containing composition and the thermal shrinkage ratio after retention under an atmosphere at 260°C for 10 minutes, of the semiconductor processing tape, was 5.0% or less, heat shrinkage of each of the tapes for semiconductor processing could be prevented even under the heating atmosphere of a reflow step (for example, under an atmosphere at about 260°C) to prevent each of the tapes for semiconductor processing from being dropped out and peeled from a ring frame. From the foregoing, each of the tapes for semiconductor processing of Examples 1 to 11 had excellent heat resistance even under the heating atmosphere of a reflow step. Each of the tapes for semiconductor processing of Examples 1 to 11 could be prevented from being peeled from a board even under an atmosphere at 260°C. It was also found from the foregoing that each of the tapes for semiconductor processing of Examples 1 to 11 could be used as a support in a reflow step and as a dicing tape for use in a dicing step.

It was also found as shown in Tables 1 and 2 above that, in each of the tapes for semiconductor processing of Examples 1 to 11, furthermore the fracture elongation at ordinary temperature was 19% or more, the fracture elongation after heating was 17% or more, flexibility at ordinary temperature and flexibility after passage through an atmosphere at 260°C were imparted, and an expanding step could be more smoothened to certainly pick up semiconductor chips. Accordingly, it was found that the degree of freedom of selection of a pickup procedure increased in each of the tapes for semiconductor processing of Examples 1 to 11. It was also found as shown in Tables 1 and 2 above that, in the tapes for semiconductor processing of Examples 1 to 11, the tensile elastic modulus under an atmosphere at 260°C was 0.8 MPa or more and each of the tapes for semiconductor processing, attached to a ring frame, could be prevented from warping in a reflow step due to the load of a device or the like mounted on the semiconductor processing tape. Here, a product increased in molecular weight of bisphenol A and a copolymer of bisphenol F and 1,6-hexanediol diglycidyl ether were used in combination as the film-forming agent in each of the tapes for semiconductor processing of Examples 1 to 11.

In particular, in Examples 2, 3, and 9 to 11 in which the blending proportion of the crosslinking component composed of an epoxy compound to the total amount of the film-forming agent and the crosslinking component composed of an epoxy compound was 50% by mass and an epoxy compound not having a cyclic hydrocarbon structure and having an elastomeric backbone and an epoxy compound having a cyclic hydrocarbon structure were blended, the fracture elongation at ordinary temperature and the fracture elongation after heating, and the tensile elastic modulus were enhanced in a well-balanced manner. In addition, also in Example 5 in which the blending proportion of the crosslinking component composed of an epoxy compound to the total amount of the film-forming agent and the crosslinking component composed of an epoxy compound was 37.5% by mass and an epoxy compound not having a cyclic hydrocarbon structure and having an elastomeric backbone and an epoxy compound having a cyclic hydrocarbon structure were blended and furthermore an organic filler was blended, the fracture elongation at ordinary temperature and the fracture elongation after heating, and the tensile elastic modulus were enhanced in a well-balanced manner.

In this regard, it was found as shown in Tables 1 and 2 above that, in each of the tapes for semiconductor processing of Comparative Examples 1 to 4 in which the substrate film was a cured product of an epoxy compound-containing composition and the thermal shrinkage ratio after retention under an atmosphere at 260°C for 10 minutes, of the semiconductor processing tape, was 6.0% or more, heat shrinkage of each of the tapes for semiconductor processing was not prevented and each of the tapes for semiconductor processing was likely dropped out and peeled from a ring frame under the heating atmosphere of a reflow step (for example, under an atmosphere at about 260°C). In addition, in each of the tapes for semiconductor processing of Comparative Examples 1 to 4, peeling of each of the tapes for semiconductor processing from a board could not be prevented and excellent tensile elastic modulus could not also be achieved under an atmosphere at 260°C.

Here, no epoxy compound was blended and only a copolymer of bisphenol F and 1,6-hexanediol diglycidyl ether was used as the film-forming agent in the semiconductor processing tape of Comparative Example 1. Only a copolymer of bisphenol F and 1,6-hexanediol diglycidyl ether was used as the film-forming agent and only an epoxy compound having a cyclic hydrocarbon structure was used as the epoxy compound in each of the tapes for semiconductor processing of Comparative Examples 2 and 3. The blending proportion of the crosslinking component composed of an epoxy compound to the total amount of the film-forming agent and the crosslinking component composed of an epoxy compound was 10% by mass in the semiconductor processing tape of Comparative Example 4.

Industrial Applicability

The semiconductor processing tape of the present invention has excellent heat resistance even under the heating atmosphere of a reflow step, and therefore has a high utility value as, for example, a semiconductor processing tape for use in a heating step at 200°C or more.

## Claims

1. A semiconductor processing tape, in which a pressure-sensitive adhesive layer is formed on a substrate film, wherein

   the substrate film is a cured product of an epoxy compound-containing composition, and
   a thermal shrinkage ratio after retention under an atmosphere at 260°C for 10 minutes, of the semiconductor processing tape, is 5.0% or less.

2. The semiconductor processing tape according to claim 1, wherein a fracture elongation under an atmosphere at 23°C, of the semiconductor processing tape, is 15% or more.

3. The semiconductor processing tape according to claim 1 or 2, wherein a fracture elongation after retention under an atmosphere at 260°C for 10 minutes, of the semiconductor processing tape, is 15% or more.

4. The semiconductor processing tape according to claim 1 or 2, wherein a tensile elastic modulus under an atmosphere at 260°C, of the semiconductor processing tape, is 0.5 MPa or more.

5. The semiconductor processing tape according to claim 1 or 2, wherein the epoxy compound-containing composition comprises at least two kinds of epoxy compounds.

6. The semiconductor processing tape according to claim 5, wherein the two kinds of epoxy compounds are an epoxy compound having a cyclic hydrocarbon structure and an epoxy compound not having a cyclic hydrocarbon structure.

7. The semiconductor processing tape according to claim 1 or 2, wherein the epoxy compound-containing composition comprises an epoxy compound having an elastomeric backbone and an epoxy compound not having an elastomeric backbone.

8. The semiconductor processing tape according to claim 6, wherein the epoxy compound not having a cyclic hydrocarbon structure is an epoxy compound having an elastomeric backbone.

9. The semiconductor processing tape according to claim 1 or 2, wherein the epoxy compound-containing composition comprises a film-forming agent and a crosslinking component composed of an epoxy compound, and a blending proportion of the crosslinking component composed of an epoxy compound to a total amount of the film-forming agent and the crosslinking component composed of an epoxy compound is 20% by mass or more and 80% by mass or less.

10. The semiconductor processing tape according to claim 1 or 2, wherein a pressure-sensitive adhesive comprised in the pressure-sensitive adhesive layer is an acrylic pressure-sensitive adhesive.

## INTERNATIONAL SEARCH REPORT

| International application No. |
| --- |
| **PCT/JP2024/003834** |

| A. | CLASSIFICATION OF SUBJECT MATTER |
| --- | --- |

*H01L 21/301*(2006.01)i; *C08G 59/02*(2006.01)i; *C08G 59/20*(2006.01)i; *C09J 7/38*(2018.01)i; *C09J 133/00*(2006.01)i
FI:   H01L21/78 M; C08G59/02; C08G59/20; H01L21/78 Q; C09J7/38; C09J133/00

According to International Patent Classification (IPC) or to both national classification and IPC

| B. | FIELDS SEARCHED |
| --- | --- |

Minimum documentation searched (classification system followed by classification symbols)

H01L21/301; C08G59/02; C08G59/20; C09J7/38; C09J133/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2022-170408 A (FUJIMORI KOGYO CO., LTD.) 10 November 2022 (2022-11-10) entire text, all drawings | 1-10 |
| A | JP 2021-068877 A (FUJIMORI KOGYO CO., LTD.) 30 April 2021 (2021-04-30) entire text, all drawings | 1-10 |
| A | JP 2012-033555 A (NITTO DENKO CORPORATION) 16 February 2012 (2012-02-16) entire text, all drawings | 1-10 |
| A | JP 2005-053998 A (NITTO DENKO CORPORATION) 03 March 2005 (2005-03-03) entire text, all drawings | 1-10 |
| A | JP 2021-153183 A (SEKISUI CHEMICAL CO., LTD.) 30 September 2021 (2021-09-30) entire text, all drawings | 1-10 |
| A | JP 2004-311750 A (TEIJIN DUPONT FILMS JAPAN LTD.) 04 November 2004 (2004-11-04) entire text, all drawings | 1-10 |

☐ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **10 April 2024** | **23 April 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/003834**

| Patent document cited in search report | | | Publication date (day/month/year) | Patent family member(s) | | | Publication date (day/month/year) |
|---|---|---|---|---|---|---|---|
| JP | 2022-170408 | A | 10 November 2022 | TW | 202249093 | A | |
| | | | | CN | 117203297 | A | |
| | | | | KR | 10-2024-0001144 | A | |
| JP | 2021-068877 | A | 30 April 2021 | CN | 112736009 | A | |
| | | | | KR | 10-2021-0050466 | A | |
| | | | | TW | 202131399 | A | |
| JP | 2012-033555 | A | 16 February 2012 | US | 2012/0025404 | A1 | |
| | | | | entire text, all drawings | | | |
| | | | | CN | 102382586 | A | |
| | | | | KR | 10-2012-0022579 | A | |
| | | | | TW | 201224101 | A | |
| JP | 2005-053998 | A | 03 March 2005 | US | 2005/0031861 | A1 | |
| | | | | entire text, all drawings | | | |
| | | | | KR | 10-2005-0016168 | A | |
| | | | | CN | 1580168 | A | |
| | | | | TW | 200511409 | A | |
| JP | 2021-153183 | A | 30 September 2021 | (Family: none) | | | |
| JP | 2004-311750 | A | 04 November 2004 | (Family: none) | | | |

Form PCT/ISA/210 (patent family annex) (July 2022)

**EP 4 675 670 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021123029 A